**Europäisches Patentamt**

**European Patent Office**

**Office européen des brevets**

(11) Publication number: **0 081 381**
**B1**

(12) **EUROPEAN PATENT SPECIFICATION**

(45) Date of publication of patent specification: **07.02.90**

(51) Int. Cl.⁵: **G 11 C 11/24**

(21) Application number: **82306520.6**

(22) Date of filing: **07.12.82**

(54) Refresh address generators for dynamic semiconductor memory devices.

(30) Priority: **07.12.81 JP 195561/81**

(43) Date of publication of application:
**15.06.83 Bulletin 83/24**

(45) Publication of the grant of the patent:
**07.02.90 Bulletin 90/06**

(84) Designated Contracting States:
**DE FR GB**

(56) References cited:
**US-A-3 753 011**
**IEEE JOURNAL OF SOLID-STATE CIRCUITS, vol.
SC-16, no. 5, October 1981, pages 492-498, IEEE,
New York, US; M. TANIGUCHI et al.: "Fully
boosted 64K dynamic RAM with automatic and
self-refresh"**
**PATENTS ABSTRACTS OF JAPAN, vol. 2, no.
156 (E-78)10217r, 11th April 1978; & JP - A - 53
126 229**
**PATENTS ABSTRACTS OF JAPAN, vol. 4, no. 91
(E-17)573r, 28th June 1980; & JP - A - 55 56724**

(73) Proprietor: **FUJITSU LIMITED
1015, Kamikodanaka Nakahara-ku
Kawasaki-shi Kanagawa 211 (JP)**

(72) Inventor: **Takemae, Yoshihiro
20-5-9-301, Utsukushigaoka 1-chome Midori-ku
Yokohama-shi Kanagawa 227 (JP)**
Inventor: **Kabashima, Katsuhiko
Fujitsu Miyauchi-ryo, 407-1 Miyauchi
Nakahara-ku Kawasaki-shi Kanagawa 211 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

The present invention relates to refresh address generators for dynamic semiconductor memory devices.

Generally, a dynamic semiconductor memory device includes a capacitor in each memory cell. The capacitor is charged or discharged to store data of, for example, "1" or "0". Because the capacitors naturally discharge however, it is necessary to cyclically recharge them in the case of "1" data, i.e. where the capacitors are originally charged up. Cyclical charging of the capacitors is known as a "refresh operation".

To effect such a refresh operation, a refresh-address signal must be cyclically applied to each memory cell. Instead of applying the address signal from the outside of the memory chip, a system is known in which a memory chip is provided with a refresh-address generator. The refresh-address generator comprises a refresh-clock generator for generating clock signals and a refresh-address counter for generating refresh-address signals in response to the clock signals. The memory cells are refreshed by the refresh-address signals.

In such a system, it is necessary to examine, especially before shipping the memory chip, whether the refresh-address generator generates the correct refresh addresses. To do this, first the operation of the memory cell array itself is examined by applying address signals from the outside, instead of from the refresh-address generator. After making sure that the memory cell array operates normally, the refresh-address generator is examined.

In a conventional dynamic semiconductor memory incorporating a refresh-address generator, the output of the refresh-address counter is not initially reset when the power supply for the memory chip is turned on. Therefore, the contents of the refresh-address counter cannot easily be determined from the outside. As a result, as hereinafter described in detail, the refresh-address generator cannot easily be examined because even when the refresh-address counter operates normally, the test data pattern written by the address signal output from the refresh-address counter during examination of the refresh-address generator will not always coincide with the data pattern read out by address signals applied from the outside.

It is therefore desirable, in order that a dynamic semiconductor memory device having a refresh-address generator can be more easily examined, to eliminate the necessity of checking the contents of the refresh-address counter before examining the refresh-address generator.

According to the present invention there is provided a refresh-address generator, in or for use in a dynamic semiconductor memory device comprising a plurality of memory cells, each having a capacitor for storing data, the generator comprising a refresh-address counter for cyclically generating address signals for use in providing refresh signals to said capacitors, and further comprising initial resetting means characterised in that said initial resetting means is operable to ensure that the first operating cycle of the said refresh-address counter commences with a predetermined one of the said address signals in response to turning-on of a power supply for supplying operating power to at least the said initial resetting means.

A refresh-address generator is disclosed in IEEE Journal of Solid-State Circuits, Vol. SC—16, No. 5, October 1981, pages 492—498, in which a reset pulse generator is employed to apply a clock signal to a refresh control circuit of the refresh-address generator when the power supply is first turned on. The applied clock signal is caused to be long enough to initialise the refresh control circuit, but short enough to prevent the flow of excessive current which may damage the refresh control circuit. There is no suggestion in this prior art document, however, that any form of initial resetting means should, or could, be used to ensure that the first operating cycle of the refresh-address counter commences with a predetermined address when the power supply is first turned on, nor is that prior art document in any way concerned with testing the refresh-address generator or with any problems associated with such testing.

Reference will now be made, by way of example, to the accompanying drawings, in which:

Fig. 1 is a block circuit diagram illustrating a conventional dynamic semiconductor memory device and refresh-address generator;

Fig. 2 is a block circuit diagram showing a detail of the refresh-address generator of Fig. 1;

Fig. 3 is a time chart for explaining the operation of the circuit of Fig. 2;

Fig. 4A is a graph;

Fig. 4B is a graph;

Fig. 5 shows circuitry included in a device embodying the present invention;

Fig. 6 is a waveform diagram; and

Fig. 7 is a block circuit diagram illustrating a refresh-address counter and its peripheral circuits, the refresh-address counter including the circuitry of Fig. 5.

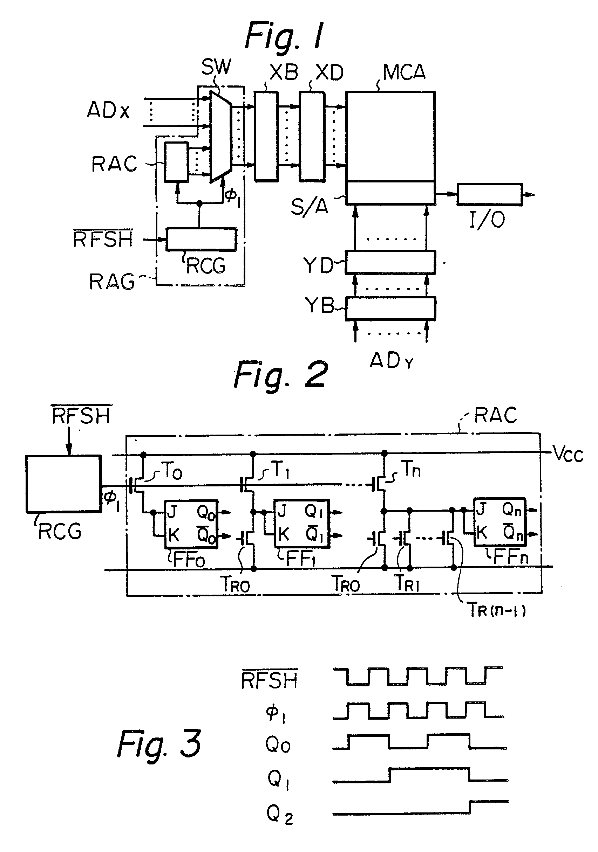

Before describing embodiments of the present invention, a conventional memory device and its problems will first be described with reference to Figs. 1 to 4B.

In Fig. 1, MCA is a memory-cell array; RAG is a refresh-address generator; XD is a row decoder; XB is a row-address buffer circuit; YD is a column decoder; YB is a column-address buffer circuit for receiving column-address signals $AD_Y$; S/A is a sense amplifier and an I/O gate; and I/O is an input/output unit. All of these elements are well known. The refresh-address generator RAG includes an address switch SW for switching between row-address signals $AD_X$ supplied from outside the memory device and refresh-address signals generated in the refresh-address generator RAG. It also includes a refresh-address

counter RAC and a refresh-control clock generator RCG.

In the operation of the device of Fig. 1, when a refresh start signal $\overline{RFSH}$ is applied to the refresh-control clock generator RCG, the generator RCG generates a clock signal $\phi_1$. The clock signal $\phi_1$ is applied to the refresh-address counter RAC and the address switch SW. In response to the clock signal $\phi_1$, the address switch SW selects the refresh-address signals from the refresh-address counter RAC to be supplied to the row-address buffer circuit XB and inhibits the row-address signals $AD_X$ from entering the row-address buffer circuit XB. Thus, row-addresses of the memory cell array are selected by the refresh-address signals so that the memory cell having the selected row-addresses are refreshed.

Figure 2 is a block circuit diagram illustrating the refresh-address counter RAC. In Fig. 2, the refresh-address counter comprises a plurality of counter stages constituted by respective flip-flops $FF_0$, $FF_1$, . . ., and $FF_n$. Each of the flip-flops has a J-input and a K-input connected to each other. Also, each flip-flop $FF_i$ (where i = 0, 1, 2, . . ., or n) has a noninverted output $Q_i$ and an inverted output $\overline{Q}_i$. The commonly connected point of the J-input and the K-input of each flip-flop $FF_i$, i.e. the input of each flip-flop $FF_i$, is connected through a metal-oxide semiconductor (MOS) transistor $T_i$ to a power supply line $V_{cc}$. The gates of the MOS transistors $T_0$, $T_1$, . . ., and $T_n$ are commonly connected to the output of the refresh-control clock generator RCG. Also, between the input of each flip-flop $FF_j$ (where j = 1, 2, . . ., or n), MOS transistor $T_{R0}$, $T_{R1}$, . . ., $T_{RW(j-1)}$ are connected in parallel. To the gates of these transistors $T_{R0}$, $T_{R1}$, . . ., and $T_{R(j-1)}$, the inverted outputs $\overline{Q}_0$, $\overline{Q}_1$, . . ., and $\overline{Q}_{j-1}$ of the previous-stage flip-flops $FF_0$, $FF_1$, . . ., and $FF_{j-1}$ are connected, respectively.

The operation of the circuit of Fig. 2 is well known and will be briefly explained with reference to Fig. 3.

Assume that all of the flip-flops $FF_0$, $FF_1$, . . ., and $FF_n$ are in a reset state, i.e. that the outputs, $Q_0$, $Q_1$, . . ., and $Q_n$ are logic "O"s when the circuit's power supply is turned on. When the refresh-control clock generator RCG generates the clock signal $\phi_1$ in response to the refresh start signal $\overline{RFSH}$, the transistors $T_0$, $T_1$, . . ., and $T_n$ are turned on, if the clock signal $\phi_1$ is logic "1". Then, in response to every rise of the clock signal $\phi_1$, the output $Q_0$ of the flip-flop $FF_0$ is changed from "0" to "1" and from "1" to "O". On the other hand, with respect to the other flip-flop $FF_i$ (where i = 1, 2, . . ., or n), the output $Q_i$ changes its state in response to the rise of the clock signal $\phi_1$ only when all of the transistors $T_{R0}$, $T_{R1}$, . . ., and $T_{R(i-1)}$ are in their off state. That is, only when all of the inverted outputs $\overline{Q}_0$, $\overline{Q}_1$, . . ., $\overline{Q}_{i-1}$ are "0" and all of the noninverted outputs $Q_0$, $Q_1$, . . ., $Q_{i-1}$ are "1" will the outputs $Q_n$ and $\overline{Q}_n$ change their states in response to the rise of the clock signal $\phi_1$. Thus, the circuit of Fig. 2 operates as a counter.

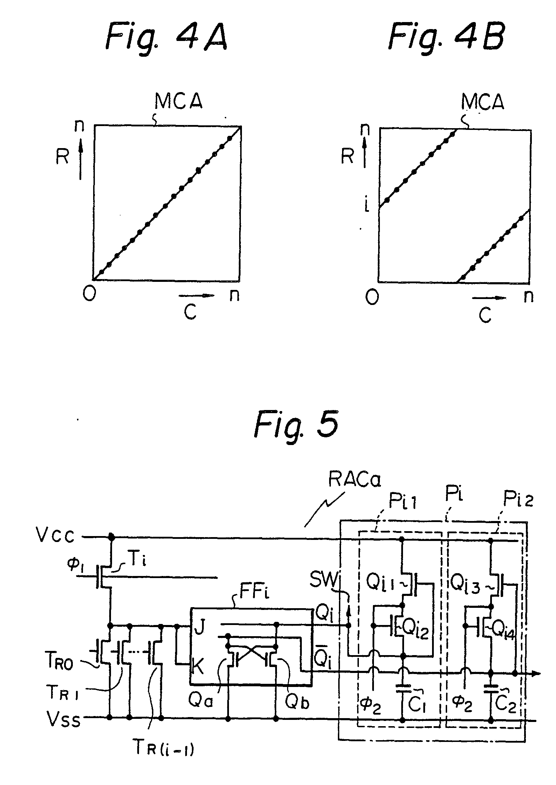

For examining the refresh-address generator, the address switch SW switches, in response to

the clock signal $\phi_1$, its input signal from the row-address signal $AD_X$ to the output signal, i.e. the refresh-address signal, from the refresh-address counter RAC. Then, test data is written into the memory-cell array MCA by accessing the array by means of the refresh-address signal as a row address and a column-address signal $AD_Y$. When the refresh-address signal is generated sequentially from "0" to "n" and the column-address signal $AD_Y$ is also generated, for example sequentially from "0" to "n", the written test data has a pattern as illustrated in Fig. 4A. In Fig. 4A, the character C represents the column address of the memory-cell array, and the character R represents the row address. As shown in Fig. 4A, the test data is written in the memory cells arranged in a diagonal line of the memory-cell array MCA. After the test data is written, the written data is read out by accessing the memory-cell array MCA by means of the row-address signal $AD_X$ and the column-address signal $AD_Y$. By checking whether the read-out data coincides with the data written into the memory-cell array MCA, it can be examined whether the refresh-address generator generates the correct refresh-address signals.

However, the refresh-address counter RAC is not always reset when the power supply is turned on. If the initial output signal of the refresh-address counter RAC is a certain value "i" not equal to zero, the refresh-address signal is generated sequentially from "i" to "n" and "0" to "i-l". In this case, when the column-address signal $AD_Y$ is sequentially generated from "0" to "n", the written test data has a pattern as illustrated in Fig. 4B. In Fig. 4B, the test data is written in two diagonal lines. Since it cannot easily be determined from what count the refresh-address counter RAC starts, it is difficult to check whether the read data coincides with the test data written into the memory-cell array MCA.

Determination of the initial output signal of the refresh-address counter before examining the refresh-address generator involves complex procedures in conventional techniques. One of the conventional procedures is to write data "1" into the memory cells in the first column by using the address signals $AD_X$ and $AD_Y$ supplied from the outside, then to write data "0" into one of the memory cells in the first column by using the intial refresh-address signal supplied by the refresh-address counter. After this, the address signals $AD_X$ and $AD_Y$ are used to sequentially read out the data stored in the memory cells in the first column. Once the row address of the read data "0" is known, the initial output of the refresh-address counter RAC can be determined. This precheck of the refresh-address counter, however, complicates the conventional examination of the refresh-address generator.

An embodiment of the present invention will now be described with reference to Figs. 5 to 7. Figure 5 shows a circuit diagram of a refresh-address counter according to an embodiment of the present invention. In Fig. 5, the refresh-address counter $RAC_a$ comprises a number of counter stages, constituted by respective flip-flops $FF_i$, and a number of pumping circuits $P_i$, where $i = 0, 1, 2, \ldots$, or n. Each flip-flop $FF_i$ corresponds to a pumping circuit $P_i$. In this embodiment, the pumping circuit $P_i$ functions as an initial resetting means for the counter $RAC_a$. Similarly to the circuit of Fig. 2, the transistors $T_{R0}$, $T_{R1}$, $\ldots$, and $T_{R(i-1)}$ are connected in parallel between the input of the flip-flop $FF_i$ and a ground line $V_{SS}$, and the transistor $T_i$ is connected between the input of the flip-flop $FF_i$ and the power supply line $V_{CC}$. The pumping circuit $P_i$ comprises a first pumping unit $P_{i1}$, consisting of MOS transistors $Q_{i1}$, $Q_{i2}$, and a capacitor $C_1$, connected in series between the power supply line $V_{CC}$ and the ground line $V_{SS}$, and a second pumping unit $P_{i2}$, consisting of MOS transistors $Q_{i3}$, $Q_{i4}$, and a capacitor $C_2$, connected in series between the power supply line $V_{CC}$ and the ground line $V_{SS}$.

In the first pumping unit $P_{i1}$, the gate and the drain of the transistor $Q_{i2}$ are commonly connected to the source of the transistor $Q_{i1}$. To the gate of the transistor $Q_{i2}$, an oscillating signal $\phi_2$, which is generated in an internal oscillation circuit (not shown) in the memory chip, is applied. The power of the internal oscillation circuit is supplied through the power supply line $V_{CC}$. The gate of the transistor $Q_{i1}$ and the source of the transistor $Q_{i2}$ are commonly connected to the noninverted output $Q_i$ of the flip-flop $FF_i$. The output $Q_i$ is connected to the address switch SW (Fig. 1). Between the source of the transistor $Q_{i2}$ and the ground line $V_{SS}$, the capacitor $C_1$ is connected.

The circuit configuration of the second pumping unit $P_{i2}$ is similar to that of the first pumping unit $P_{i1}$, except that the gate of the transistor $Q_{i3}$ and the source of the transistor $Q_{i4}$ are commonly connected to the inverted output $\overline{Q_i}$ of the flip-flop $FF_i$.

The capacitance of the capacitor $C_1$ is selected to be smaller than the capacitance of the capacitor $C_2$, for the purpose of effecting the initial resetting operation as hereinafter described. The flip-flop $FF_i$ comprises, as is well known, transistors $Q_a$ and $Q_b$ cross-coupled to each other.

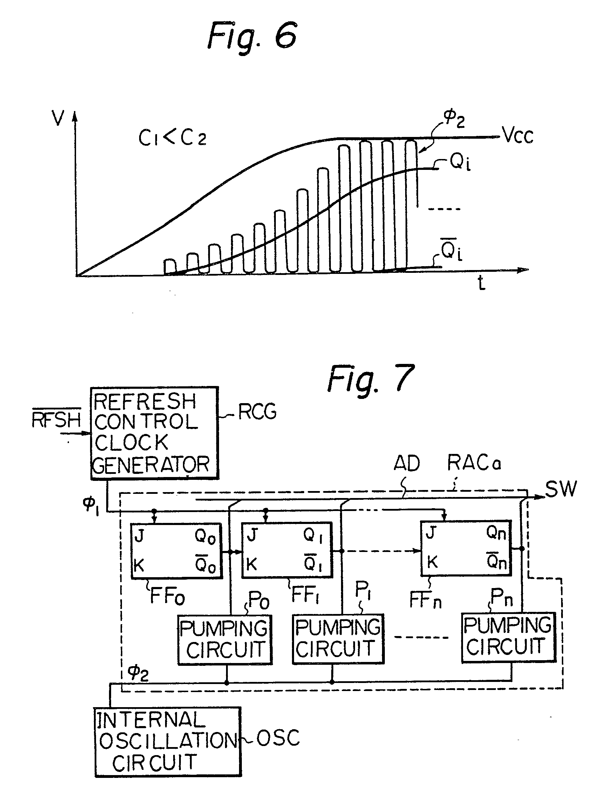

The initial resetting operation by the circuit of Fig. 5 will now be described with reference to Fig. 6. In Fig. 6, in response to a rise of the potential of the power supply line $V_{CC}$ by turning on the power supply of the memory device, the amplitude of the oscillating signal $\phi_2$ generated in the internal oscillation circuit (not shown) also gradually rises. Because the capacitance of the capacitor $C_1$ is smaller than the capacitance of the capacitor $C_2$, the potential at the source of the transistor $Q_{i2}$ rises earlier than the potential at the source of the transistor $Q_{i4}$. Therefore, the potential difference between the outputs $Q_i$ and $\overline{Q_i}$ of the flip-flop $FF_i$ also increases in response to the rise of potential of the power supply line $V_{CC}$. The flip-flop $FF_i$ detects this potential difference and latches the transistors $Q_a$ and $Q_b$ on and off, respectively. Thus, all of the flip-flops $FF_0$, $FF_1$, $\ldots$, and $FF_n$ are initially reset so that they provide all "1" or all "0" outputs.

If the transistor $Q_a$ has a higher mutual conductance $g_m$ than that of the transistor $Q_b$, the transistor $Q_a$ is more easily turned on than the transistor $Q_b$, so that the above-mentioned latching operation is effected more efficiently.

Figure 7 is a block circuit diagram illustrating a refresh-address counter $RAC_a$ including the pumping circuits $P_0$, $P_1$, $\ldots$, and $P_n$ and its peripheral circuits. As will be apparent from the above description with reference to Figs. 5 and 6, by using, when the power supply is turned on, the rise of the internal oscillating signal $\phi_2$ output from the interal oscillation circuit OSC, the pumping circuits $P_0$, $P_1$, and $P_n$ operate to reset all of the flip-flops $FF_0$, $FF_1$, $\ldots$, and $FF_n$, respectively, to provide the same outputs "1" or "0". The outputs of the flip-flops $FF_0$ through $FF_n$ are transferred through an address bus AD to the address switch SW (Fig. 1). Since all of the flip-flops are initially reset, it is possible to eliminate the procedure of determining the initial output state of the refresh-address counter $RAC_a$ before examining the refresh-address generator.

It will be appreciated that, in use of the above-described embodiment of the invention, it is not necessary to check the output state of the refresh-address counter before examining the refresh-address generator in a dynamic semiconductor memory device. Accordingly, the examination of the refresh-address generator can be effected more easily and in a shorter time than in the conventional technique.

The present invention is not restricted to the foregoing embodiment. For example, the first capacitance $C_1$ may have a larger capacitance than the second capacitance $C_2$. Also, the transistor $Q_a$ may have a lower mutual conductance $g_m$ than that of the transistor $Q_b$. Further, simpler or more complex test patterns than the test pattern of Fig. 4A are possible. Still further, in place of the pumping circuits, any other initial resetting means for setting the output of the refresh address counter RAC to a predetermined value may be employed.

**Claims**

1. A refresh-address generator, in or for use in a dynamic semiconductor memory device comprising a plurality of memory cells (MCA), each having a capacitor for storing data, the generator comprising a refresh-address counter (RAC) for cyclically generating address signals for use in providing refresh signals to said capacitors, and further comprising initial resetting means characterised in that said initial resetting means ($P_i$) is operable to ensure that the first operating cycle of the said refresh-address counter commences with a predetermined one of the said address signals in response to turning-on of a power supply for supplying operating power to at least the said initial resetting means.

2. A generator as claimed in claim 1, further comprising oscillation circuitry connected to share said power supply with said initial resetting means ($P_i$) and operative to provide an oscillating signal ($\phi_2$), said initial resetting means comprising

pumping circuits ($P_0$, $P_1$, ...) associated respectively with successive counter stages ($FF_0$, $FF_1$, ...) of the refresh-address counter (RAC) and having respective inputs connected to receive said oscillating signal, each of the said pumping circuits ($P_0$, $P_1$, ...) having two outputs at which respective voltages that increase with different respective rise times are produced by the circuit in response to an increase in amplitude of the said oscillating signal after the said power supply is turned on, and the said two outputs of each pumping circuit ($P_0$, $P_1$, ...) being connected respectively to output points of the counter stage ($FF_0$, $FF_1$, ...) associated with that circuit.

3. A generator as claimed in claim 2, wherein each of the said counter stages ($FF_0$, $FF_1$, ...) comprises a flip-flop ($FF_i$) having a non-inverted output ($Q_i$) and a inverted output ($\overline{Q}_i$) providing respectively the said output points of the counter stage.

4. A generator as claimed in claim 3, wherein each of said pumping circuits ($P_0$, $P_1$, ...) comprises a first pumping unit ($P_{i1}$) and a second pumping unit ($P_{i2}$); said first pumping unit ($P_{i1}$) comprising a first MOS transistor ($Q_{i1}$), and a second MOS transistor ($Q_{i2}$), and a first capacitor ($C_1$) connected in series between a power supply line ($V_{cc}$) of the said memory device, on which the said power supply is provided, and a ground line ($V_{ss}$) of the said memory device, a gate of said second MOS transistor ($Q_{i2}$) and a source of said first MOS transistor ($Q_{i1}$) both being connected to receive the oscillating signal ($\phi_2$) from said oscillation circuitry, a gate of said first MOS transistor ($Q_{i1}$) and a source of said second MOS transistor ($Q_{i2}$) both being connected to one of the said output points of the flip-flop ($FF_i$) associated with the pumping circuit concerned; said second pumping unit ($P_{i2}$) comprising a third MOS transistor ($Q_{i3}$), a fourth MOS transistor ($Q_{i4}$), and a second capacitor ($C_2$) connected in series between said power supply line ($V_{cc}$) and said ground line ($V_{ss}$), a gate of said fourth MOS transistor ($Q_{i4}$) and a source of said third MOS transistor ($Q_{i3}$) both being connected to receive the oscillating signal ($\phi_2$) from said oscillation circuitry, a gate of said third transistor ($Q_{i3}$) and a source of said fourth MOS transistor ($Q_{i4}$) both being connected to the other of the said output points of the said flip-flop ($FF_i$).

5. A generator as claimed in claim 4, wherein the capacitance of said first capacitor ($C_1$) is different from the capacitance of said second capacitor ($C_2$).

6. A generator as claimed in any one of claims 3 to 5, wherein each of the said flip-flops ($FF_0$, $FF_1$, ...) comprises two transistors ($Q_a$, $Q_b$) cross-coupled to one another, said two transistors having different mutual conductances.

**Patentansprüche**

1. Auffrisch-Adreßgenerator in oder zur Verwendung in einer dynamischen Halbleiterspeichervorrichtung, mit einer Veilzahl von Speicherzellen (MCA), die jeweils einen Kondensator zum Speichern von Daten haben, welcher Generator einen Auffrisch-Adreßzähler (RAC) zum zyklischen Generieren von Adreßsignalen zur Verwendung bei der Lieferung von Auffrisch-Signalen zu den genannten Kondensatoren umfaßt, und ferner mit einer Initial-Rücksetzeinrichtung, dadurch gekennzeichnet, daß die genannte Initial-Rücksetzeinrichtung ($P_i$) betreibbar ist, um sicherzustellen, daß der erste Operationszyklus des genannten Auffrisch-Adreßzählers mit einem vorbestimmten der genannten Adreßsignale beginnt, ansprechend auf das Einschalten einer Energieversorgung zur Lieferung von Betriebsenergie zu wenigstens der genannten Initial-Rücksetzeinrichtung.

2. Generator nach Anspruch 1, ferner mit einer Oszillationsschaltung, die verbunden ist, um die gennante Energieversorgung mit der genannten Initial-Rücksetzeinrichtung ($P_i$) zu teilen, und betreibbar ist, um ein Oszillationssignal ($P_2$) zu liefern, welche genannte Initial-Rücksetzeinrichtung Pumpenschaltungen ($P_0$, $P_1$, ...) umfaßt, die jeweils mit aufeinander folgenden Zählstufen ($FF_0$, $FF_1$, ...) des Auffrisch-Adreßzählers (RAC) verbunden sind und jeweils Eingänge haben, die verbunden sind, um das genannte Oszillationssignal zu empfangen, wobei jede der genannten Pumpenschaltungen ($P_0$, $P_1$, ...) zwei Ausgänge hat, an denen entsprechende Spannungen, welche mit verschiedenen jeweiligen Anstiegszeiten, größer werden, durch die Schaltung erzeugt werden, ansprechend auf ein Anwachsen in der Amplitude des genannten Oszillationssignals, nachdem die genannte Energieversorgung eingeschaltet worden ist, und die gennanten beiden Ausgänge jeder Pumpenschaltung ($P_0$, $P_1$, ...) jeweils mit Ausgangspunkten der Zählstufe ($FF_0$, $FF_1$, ...) verbunden sind, die jener Schaltung zugeordnet sind.

3. Generator nach Anspruch 2, bei dem jede der genannten Zählstufen ($FF_0$, $FF_1$, ...) ein Flipflop ($FF_i$) umfaßt, das einen nichtinvertierten Ausgang ($Q_1$) und einen invertierten Ausgang ($\overline{Q}_1$) hat, die jeweils die genannten Ausgangspunkte der Zählstufe bilden.

4. Generator nach Anspruch 3, bei dem jede der genannten Pumpenschaltungen ($P_0$, $P_1$, ...) eine erste Pumpeneinheit ($P_{i1}$) und eine zweite Pumpeneinheit ($P_{i2}$) umfaßt; die genannte erste Pumpeneinheit ($P_{i1}$) einen ersten MOS-Transistor ($Q_{i1}$) und einen zweiten MOS-Transistor ($Q_{i2}$) und einen ersten Kondensator ($C_1$) umfaßt, die in Reihe zwischen der Energieversorgungsleitung ($V_{cc}$) der genannten Speichervorrichtung, auf der die genannte Energieversorgung vorgesehen ist, und einer Erdleitung ($V_{ss}$) der genannten Speichervorrichtung verbunden sind, wobei ein Gate des genannten zweiten MOS-Transistors ($Q_{i2}$) und eine Source des genannten ersten MOS-Transistors ($Q_{i1}$) beide verbunden sind, um das Oszillationssignal ($\phi_2$) von der genannten Oszillationsschaltung zu empfangen, ein Gate des genannten ersten MOS-Transistors ($Q_{i1}$) und eine Source des genannten zweiten MOS-Transistors

($Q_{i2}$) beide mit einem der genannten Ausgangspunkte des Flipflops ($FF_i$) verbunden sind, welches der betreffenden Pumpenschaltung zugeordnet ist; die genannte zweite Pumpeneinheit ($P_{i2}$) eine dritten MOS-Transistor ($Q_{i3}$), einen vierten MOS-Transistors ($Q_{i4}$) und einen zweiten Kondensator ($C_2$) umfaßt, die in Reihe zwischen der genannten Energieversorgungsleitung ($V_{cc}$) und der genannten Erdleitung ($V_{ss}$) verbunden sind, ein Gate des genannten vierten MOS-Transistors ($Q_{i4}$) un eine Source des genannten dritten MOS-Transistors ($Q_{i3}$) beide verbunden sind, um das Oszillationssignal ($\phi_2$) von der genannten Oszillationsschaltung zu empfangen, ein Gate des genannten dritten MOS-Transistors ($Q_{i3}$) und eine Source des genannten vierten MOS-Transistors ($Q_{i4}$) beide mit dem anderen der genannten Ausgangspunkte des genannten Flipflops ($FF_i$) verbunden sind.

5. Generator nach Anspruch 4, bei dem die Kapazität des genannten ersten Kondensators ($C_1$) von der Kapazität des genannten zweiten Kondensators ($C_2$) verschieden ist.

6. Generator nach einem der Ansprüche 3 bis 5, bei dem jedes der genannten Flipflops ($FF_0$, $FF_1$, . . .) zwei Transistoren ($Q_a$, $Q_b$), umfaßt, die über Kreuz miteinander gekoppelt sind, welche genannten beiden Transistoren wechselseiting verschiedene Konduktanzen haben.

**Revendications**

1. Générateur d'adresses de régénération, fonctionnant ou servant dans un dispositif de mémoire dynamique à semiconducteur comprenant un ensemble de cellules de mémoire (MCA), chacune comportant un condensateur pour mémoriser un donnée, le générateur comprenant un compteur d'adresse de régénération (RAC) pour engendrer cycliquement des signaux d'adresse servant à fournir des signaux de régénération aux condensateurs, et comprenant en outre un moyen de remise à l'état initial caractérisé en ce que le moyen de remise à l'état initial ($P_i$) peut être mis en fonctionnement pour garantir que le premier cycle de fonctionnement du compteur d'adresse de régénération commence avec un signal prédéterminé parmi les signaux d'adresse en réponse à la mise en circuit d'une source d'alimentation pour fournir une tension d'alimentation de fonctionnement au moins au moyen de remise à l'état initial.

2. Générateur selon la revendication 1, comprenant en outre un circuit d'oscillation connecté pour partager la source d'alimentation avec le moyen de remise à l'état initial ($P_i$) et pouvant fonctionner pour fournir un signal oscillant ($\phi_2$), le moyen de remise à l'état initial comprenant des circuits de pompage ($P_0$, $P_1$, . . .) respectivement associés à des étages successifs de compteur ($FF_0$, $FF_1$, . . .) du compteur d'adresse de régénération (RAC) et ayant des entrées respectives connectées pour recevoir le signal oscillant, chacun des circuits de pompage ($P_0$, $P_1$, . . .) ayant deux sorties où sont produites des tensions respectives qui augmentent avec différents temps de montée respectifs par le circuit en réponse à une augmentation de l'amplitude du signal oscillant après la mise en circuit de la source d'alimentation, et les deux sorties de chaque circuit de pompage ($P_0$, $P_1$, . . .) étant respectivement connectées à des points de sortie de l'étage de compteur ($FF_0$, $FF_1$, . . .) associé à ce circuit.

3. Générateur selon la revendication 2, dans lequel chacun des étages de compteur ($FF_0$, $FF_1$, . . .) comprend une bascule ($FF_i$) ayant une sortie non inversée ($Q_i$) et une sortie inversée ($\overline{Q}_i$) constituant respectivement les points de sortie de l'étage de compteur.

4. Générateur selon la revendication 3, dans lequel chacun des circuits de pompage ($P_0$, $P_1$, . . .) comprend une première unité de pompage ($P_{i1}$) et une deuxième unité de pompage ($P_{i2}$); la première unité de pompage ($P_{i1}$) comprenant un premier transistor à métal-oxyde-semiconducteur MOS ($Q_{i1}$) et un deuxième transistor MOS ($Q_{i2}$), et un premier condensateur ($C_1$) connecté en série entre un fil de tension d'alimentation ($V_{cc}$) du dispositif de mémoire, sur lequel est prévue la source d'alimentation, et un fil de masse ($V_{ss}$) du dispositif de mémoire, un grille du deuxième transistor MOS ($Q_{i2}$) et une source de premier transistor MOS ($Q_{i1}$) étant toutes les deux connéc-tées pour recevoir le signal oscillant ($\phi_2$) du circuit d'oscillation, une grille du premier transistor MOS ($Q_{i2}$) et une source du deuxième transistor MOS ($Q_{i}2$) étant toutes les deux connectées à un des points de sortie de la bascule ($FF_i$) associée au circuit de pompage concerné; la deuxième unité de pompage ($P_{i2}$) comprenant un troisième trans-istor MOS ($Q_{i3}$), un quatrième transistor MOS ($Q_{i4}$), et un deuxième condensateur ($C_2$) connecté en série entre le fil de tension d'alimentation ($V_{cc}$) et le fil de masse ($V_{ss}$), un grille du quatrième transistor MOS ($Q_{i4}$) et un source du troisième transistor MOS ($Q_{i3}$) étant toutes les deux connectées pour recevoir le signal oscillant ($\phi_2$) du circuit d'oscillation, une grille du troisième transistor MOS ($Q_{i3}$) et une source du quatrième transistor MOS ($Q_{i4}$) étant toutes les deux connectées à l'autre des points de sortie de la bascule ($FF_i$).

5. Générateur selon la revendication 4, dans lequel la capacité du premier condensateur ($C_1$) est différente de la capacité du deuxième conden-sateur ($C_2$).

6. Générateur selon l'une quelconque des revendications 3 à 5, dans lequel chacune des bascules ($FF_0$, $FF_1$, . . .) comprend deux transistors ($Q_a$, $Q_b$) à couplage croisé entre eux, les deux transistors ayant des conductances mutuelles dif-férentes.

# Fig. 1

# Fig. 2

# Fig. 3

EP 0 081 381 B1

## Fig. 4A

MCA

## Fig. 4B

MCA

## Fig. 5

2

# Fig. 6

# Fig. 7